Europäisches Patentamt

European Patent Office

Office européen des brevets

(11) Veröffentlichungsnummer: **0 236 830**

**A2**

(12) # EUROPÄISCHE PATENTANMELDUNG

(21) Anmeldenummer: **87102549.0**

(22) Anmeldetag: **23.02.87**

(51) Int. Cl.⁴: **H05K 1/03**

(30) Priorität: **07.03.86 ES 292827 U**

(43) Veröffentlichungstag der Anmeldung:
**16.09.87 Patentblatt 87/38**

(84) Benannte Vertragsstaaten:
**AT BE CH DE FR GB IT LI LU NL SE**

(71) Anmelder: **CIRCUITGRAPH, S.L.**
**4, Nunez Morgado Street**
**E-28036 Madrid(ES)**

(72) Erfinder: **Melero, Pedro Valenciano**
**27, Marqués de Lozova Street**
**E-28007 Madrid(ES)**

(74) Vertreter: **Zinnecker, Armin et al**
**Widenmayerstr. 23**
**D-8000 München 22(DE)**

(54) **Grundplatte für elektrische Stromkreise.**

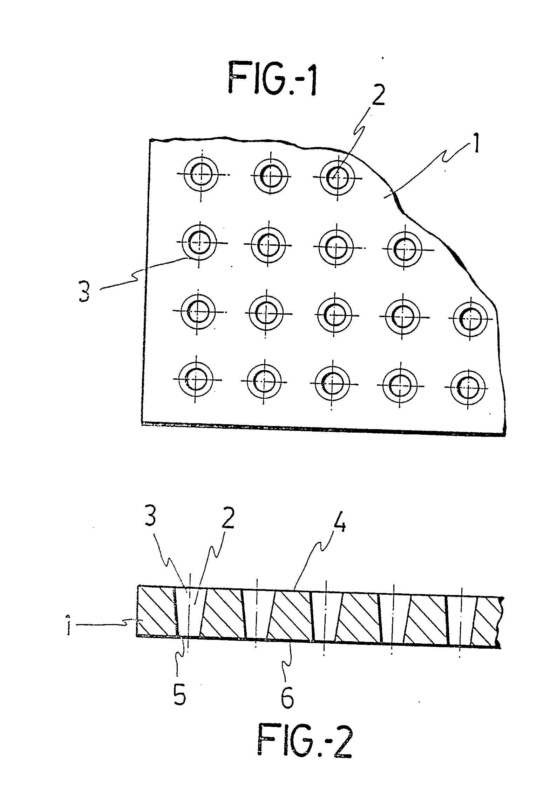

(57) Eine Grundplatte (1) für elektrische Stromkreise besteht aus einem isolierenden, mit Durchgangslöchern (2) versehenen Schichtkörper. Damit die elektrischen Stromkreise einfacher und schneller hergestellt werden können, sind die Durchgangslöcher (2) kegelstumpfförmig, wobei der größere Durchmesser des Kegelstumpfs größer und der kleinere Durchmesser des Kegelstumpfs kleiner ist als der Durchmesser der Anschlußteile der zu verbindenden elektrischen Bauteile (Fig. 2).

FIG.-2

EP 0 236 830 A2

## Grundplatte für elektrische Stromkreise

Die Erfindung betrifft eine Grundplatte für elektrische Stromkreise, bestehend aus einem isolierenden, mit Durchgangslöchern versehenen Schichtkörper, nach dem Oberbegriff des Anspruchs 1.

Derartige Grundplatten sind aus den spanischen Patentschriften 538 302 und 544 000 der Anmelderin bekannt. Die vorbekannten Grundplatten dienen zur Herstellung von experimentellen oder als Prototyp dienenden Stromkreisen, also zur Herstellung elektrischer Stromkreise, die sich nicht sehr häufig wiederholen. Dabei ist die Grundplatte aus elektrisch isolierendem Material mit Bohrungen zum Zwecke der Verriegelung der elektrischen, an dem Stromkreis teilnehmenden Bauteile ausgestattet. Zunächst werden die elektrischen Bauteile mit ihren Anschlußteilen in die Durchgangslöcher eingesetzt. Anschließend wird ein Leitungsdraht um die Anschlußteile (Pratzen) der Bauteile gewickelt. Aus den genannten spanischen Patentschriften ist weiterhin ein Gerät bekannt, das die Wicklungsoperationen des Leitungsdrahtes um die Anschlußteile (Pratzen) der Bauteil erleichtert.

Nach der Einführung der Anschlußteile der elektrischen Bauteile in die Öffnungen der Grundplatte wird es also notwendig, die Grundplatte umzudrehen, damit die Anschlußteile sich während der Verdrahtung in einer leicht zugänglichen Stellung befinden. Es ist also erforderlich, die elektrischen Bauteile während der Phase der Verdrahtungsoperation an der Grundplatte zu befestigen, um die Grundplatte umdrehen zu können, ohne daß die Bauteile herausfallen. Um dies zu ermöglichen, wird in den genannten spanischen Patentschriften vorgeschlagen, einen schwammförmigen Körper vorzusehen, der auf die Seite der Grundplatte gestützt ist, auf der die Bauteile festgelegt werden, und der in zweckmäßiger Form an der Grundplatte befestigt sein muß. Der schwammförmige Körper dient also als Mittel zum Festhalten der elektrischen Bauteile in ihrer Stellung. Die von den oben genannten Patentschriften vorgeschlagene Grundplatte ist inbesondere auch deshalb entworfen worden, um eine Möglichkeit dafür zu bieten, diese operative Phase bei dem bereits genannten Verfahren auszuscheiden, und insbesondere die "Selbstbefestigung" der elektrischen Bauteile an die Grundplatte sicherzustellen, ohne daß hierfür zusätzlich noch irgendwelche anderen Befestigungsmittel benötigt werden.

Herkömmlicherweise enthalten die Grundplatten für elektrische Stromkreise eine Vielzahl von zylindrischen Öffnungen mit geeignetem Durchmesser, wobei die Lage der Öffnungen an die geometrischen Anordnungen (Schablonen) angepaßt ist, die von den Herstellern der elektrischen Bauteile und Materialien vorgegeben werden bzw. genormt sind. Damit die Bauteile schnell und einfach montiert werden können, müssen die genannten Öffnungen im Verhältnis zu dem Durchmesser der Anschlußteile (Pratzen) der Bauteile leicht überdimensioniert sein. Aus diesem Grund ist die bereits oben genannte operative Phase erforderlich, die darin besteht, die Bauteile durch irgendein herkömmliches Mittel an der Grundplatte während der Operationsphase der elektrischen Schaltung zu befestigen, bei der die Grundplatte eine umgedrehte Stellung einnehmen muß und die elektronischen Komponenten noch "lose" gehalten werden.

Aufgabe der Erfindung ist es, eine Grundplatte für elektrische Stromkreise der eingangs angegebenen Art zu schaffen, mit der elektrische Stromkreise einfacher und schneller hergestellt werden können.

Erfindungsgemäß wird diese Aufgabe durch die kennzeichnenden Merkmale des Anspruchs 1 gelöst. Die Durchgangslöcher sind kegelstumpfförmig, wobei der größere Durchmesser des Kegelstumpfs größer und der kleinere Durchmesser des Kegelstumpfs kleiner ist als der Durchmesser der Anschlußteile (Pratzen) der zu verbindenden elektrischen Bauteile (elektronischen Komponenten). Durch diese Ausgestaltung der Durchgangslöcher (Öffnungen) wird erreicht, daß die elektrischen Bauteile an der Grundplatte im Augenblick ihrer Anbringung auf der Platte befestigt werden. Die Einmündung des Durchgangslochs mit dem größeren Durchmesser liegt auf der Seite der Grundplatte, auf der auch die elektrischen Bauteile zu liegen kommen. Der größere Durchmesser ist in einer Weise größer als die Anschlußteile der Bauteile, die diesen Anschlußteilen den Zugang zum Innern der Öffnung erleichtert. Die andere Einmündung der Durchgangslöcher, also das Ausgangsmundstück der Anschlußteile der zu verbindenden Bauteile, hat einen etwas kleineren Durchmesser als diese Anschlußteile, so daß bei der bereits mehrfach genannten Operation der Anbringung der Bauteile (Komponenten) ihre Anschlußteile (Pratzen) "forziert" werden müssen, also mit einem gewissen Kraftaufwand durch den kleineren Durchmesser des Durchgangslochs hindurchgedrückt werden müssen, um zu erreichen, daß die Anschlußteile vollständig durch die Grundplatte hindurchgehen. Dadurch wird eine "Anhaftung" der kleineren Einmündung der Öffnungen an den Anschlußteilen erreicht, also eine reibschlüssige Befestigung, wodurch die Unbeweglichkeit der Bauteile während der Operationsphase der Herstellung einer Verbundschaltung derselben gesichert wird. Die Anschlüsse, also die Verbindungen der elektrischen Bauteile, werden auf der Seite der Grundplatte durchgeführt, die den elektrischen Bauteilen gegenüberliegt. Die Anschlüsse werden mittels direkter Verdrahtung oder, genauer gesagt, mittels Umwicklung der Enden des Leitungsdrahtes auf den entsprechenden Anschlußteilen (Pratzen) der elektrischen Bauteile - (Komponenten) hergestellt. Die Anschlußteile der zu verbindenden elektrischen Bauteile müssen durch die kleinere Öffnung des kegelstumpfförmig ausgebildeten Durchgangslochs hindurchgedrückt werden, so daß sie sich in diesem Durchgangsloch selbst befestigen, wodurch eine stabile Kupplung der Bauteile an die Grundplatte sichergestellt wird und auf diese Weise ein Umdrehen der Grundplatte unter Aufrechterhaltung der Verriegelungslage zur Durchführung der Anschlußoperation ermöglicht wird.

Eine weitere Aufgabe der Erfindung besteht darin, eine Grundplatte für elektrische Stromkreise zu schaffen, die für die praktische Unterweisung auf dem Gebiet der Elektronik geeignet ist, die also ein besonders gutes Verständnis des zu - schaffenden Stromkreises ermöglicht.

Die Aufgabe wird dadurch gelöst, daß der die Grundplatte bildende Schichtkörper durchsichtig ist. Dadurch, daß der Schichtkörper transparent und durchscheinend ist, sind die elektrischen Bauteile auch dann sichtbar, wenn die Verdrahtungsoperation ausgeführt wird, wenn sich die Bauteile also auf der den Anschlußteilen gegenüberliegenden Seite der Grundplatte befinden. Die Bauteile sind also auch dann sichtbar, wenn man die Platte mit dem bereits verdrahteten Stromkreis von der anderen Seite her betrachtet. Dementsprechend sind die Verdrahtungen auch dann sichtbar, wenn man die Grundplatte von der Seite der elektrischen Bauteile her betrachtet.

Die kegelstumpfförmigen Öffnungen können auf der Grundplatte mit einer Dichte und Verteilung angeordnet sein, die den Bestimmungen der zu diesem Zweck standarisierten Schablonen entsprechen, so daß damit die Grundplatte für alle Arten von Montagen geeignet ist, ohne daß für den Benutzer die Notwendigkeit besteht, weitere Bohrungen vorzunehmen.

Aus den obigen Ausführungen ergibt sich daher, daß die vorgeschlagene Grundplatte für die Ausführung von experimentellen Stromkreisen gemäß dem in dem bereits vorher genannten spanischen Patenten aufgeführten Verfahren und Gerät besonders geeignet ist, in erster Linie jedoch für die Ausführungen von experimentellen und als Prototypen dienenden Stromkreisen.

Nachstehend wird ein Ausführungsbeipiel der Erfindung anhand der Zeichnungen im einzelnen beschrieben. In diesen zeigt:

Figur 1 in einer teilweisen Draufsicht eine Grundplatte zur Ausführung von elektrischen Stromkreisen nach der Erfindung und

Figur 2 einen Ausschnitt der in Figur 1 dargestellten Platte auf der Höhe einer der dort vorgesehenen Öffnungsreihen.

Wie aus den beiden Figuren ersichtlich, besteht die erfindungsgemäße Grundplatte aus einem elektrisch isolierenden Schichtkörper, dessen Größe der vorgesehenen, spezifischen Anwendung entspricht. Auf der Grundplatte ist eine Vielzahl von Öffnungen 2 mit einer Dichte und Verteilung vorhanden, die mit den Vorschriften der von den Herstellern der elektronischen Bauteile - (Komponenten) und Materialien standarisierten Schablonen übereinstimmt.

Die Öffnungen 2 haben, wie aus Figur 2 ersichtlich, eine kegelstumpfförmige Gestalt. Der Durchmesser der Einmündungen 3 der Öffnungen 2 ist wesentlich größer als der der Anschlußteile (Pratzen) der elektrischen Bauteile (elektronischen Komponenten), die auf der Platte 1 angebracht werden sollen, wobei die genannten Einmündungen 3 mit ihrem größeren Durchmesser auf die Seite 4 der Platte hin ausgerichtet sind, die dazu bestimmt ist, die genannten Bauteile aufzunehmen, während die mit einem kleineren Durchmesser versehenen Einmündungen 5, die auf der anderen Seite 6 der Platte vorgesehen sind, einen etwas kleineren Durchmesser als den Durchmesser der Anschlußteile der Bauteile aufweisen. Der Durchmesser der Einmündungen 5 ist so ausgestaltet, daß die Anschlußteile der Bauteile, die leicht Zugang zu der Ausbuchtung 5 der Öffnungen 2 auf der Seite 4 der Platten haben, in dem Augenblick, in dem sie die Ausgangszone 5 erreichen, dank der durch die Einmündungen 5 eingetretenen Durchmesserverengung in ihrer axialen Verschiebung verstärkt werden müssen, also mit einem gewissen Kraftaufwand hineingeschoben werden müssen, wodurch sie über die Platte 1 in einer Verriegelungs-oder Selbstbefestigungsstellung hinausragen. Dadurch sind die Bauteile fest und reibschlüssig mit der Platte verbunden. Die Platte kann umgedreht werden, ohne daß die Gefahr einer Ablösung der Bauteile besteht, um die erforderlichen Verdrahtungsoperationen auf den äußeren Sektoren (Enden) der Anschlußteile (Pratzen) der Bauteile - (Komponenten) durchführen zu können, die aus der Grundplatte 1 auf der Seite herausragen, die derjenigen Seite gegenüberliegt, auf der die eigentlichen Bauteile befestigt werden.

Naturgemäß soll der Unterschied in den Durchmesser zwischen der Einmündung 5 der Öffnungen 2 und der Anschlußteile der Bauteile so klein wie nur irgend möglich sein, um die Gefahr auszuschliessen, daß die Anschlußteile übermäßig hineingedrückt werden müssen und dabei deformiert werden.

Ergänzend ist die Möglichkeit vorgesehen, daß der Schichtkörper 1 der Grundplatte transparent oder durchscheinend ist, um die Bauteile von der Anschlußseite zwischen den Anschlußteilen direkt sichtbar zu machen, oder aber die Verbindung zwischen den Anschlußteilen auf der Seite der Bauteile sichtbar zu machen, um das Verständnis des auszuführenden Stromkreises zu erleichtern und ohne Schwierigkeiten etwaige Anschlußfehler usw. feststellen zu können.

**Ansprüche**

1. Grundplatte (1) für elektrische Stromkreise, bestehend aus einem isolierenden, mit Durchgangslöchern (2) versehenen Schichtkörper, **dadurch gekennzeichnet,** daß die Durchgangslöcher (2) kegelstumpfförmig sind, wobei der größere Durchmesser des Kegelstumpfs größer und der kleinere Durchmesser des Kegelstumpfs kleiner ist als der Durchmesser der Anschlußteile der zu verbindenden elektrisschen Bauteile.

2. Grundplatte nach Anspruch 1, dadurch gekennzeichnet, daß der Schichtkörper durchsichtig ist.

# FIG.-1

# FIG.-2